# EUROPEAN PATENT APPLICATION

(11) **EP 4 679 775 A1**
(43) Date of publication of application: **14.01.2026**
(21) Application number: 24187917.0
(22) Date of filing: 11.07.2024
(51) Int. Cl.: H04L 12/10, H04L 12/40, H04L 12/46, H01M 10/42

(54) **VOLTAGE LEVEL TRANSLATOR AND BATTERY SYSTEM**

(71) Applicant: HELLA GmbH & Co. KGaA, 59552 Lippstadt (DE)
(72) Inventor: AVRAM, Sebastian, 300724 Timisoara (RO); OPROIU, George Cristian, Mun. Craiova, Jud. Dolj (RO); NASTASSE, Eugen, 300362 Timisoara (RO); TALOI, Marius Stefanel, 220200 Drobeta Turnu-Severin (RO)
(74) Representative: Behr-Wenning, Gregor

(57) **Abstract**

The present invention relates to a voltage level translator device (100) for a data bus (19), comprising: a first data bus terminal (8), a first supply voltage terminal (6), a first reference voltage terminal (7), a second data bus terminal (11), a second supply voltage terminal (9) and a second reference voltage terminal (10), a first transceiver unit (14) comprising a transmit line terminal (14.4) and a receive line terminal (14.5), wherein the first transceiver unit (14) is powered via the first supply voltage terminal (6) and the first reference voltage terminal (7) and is connected to the first data bus terminal (8), a first galvanically isolated signal transmission unit (16) connected to the transmit line terminal (14.4) of the first transceiver unit (14), a second galvanically isolated signal transmission unit (17) connected to the receive line terminal (14.5) of the first transceiver unit (14), a second transceiver unit (15) comprising a transmit line terminal (15.4) and a receive line terminal (15.5), wherein the second transceiver unit (15) is powered via the second supply voltage terminal (9) and the second reference voltage terminal (10) and is connected to the second data bus terminal (11), and a translation unit (18) comprising a first transmit line terminal (18.3) connected to the first galvanically isolated signal transmission unit (16), a first receive line terminal (18.4) connected to the second galvanically isolated signal transmission unit (17), a second transmit line terminal (18.5) connected to the transmit line terminal (15.4) of the second transceiver unit (15), and a second receive line terminal (18.6) connected to the receive line terminal (15.5) of the second transceiver unit (15), wherein the translation unit (18) is powered via the second supply voltage terminal (9) and the second reference voltage terminal (10), and wherein the translation unit (18) is configured to receive data via the first receive line terminal (18.4) and transmit the received data in a protocol-compliant manner via the second transmit line terminal (18.5), and to receive data via the second receive line terminal (18.6) and transmit the received data in a protocol-compliant manner via the first transmit line terminal (18.3).

## Description

The present invention relates to a voltage level translator device for a data bus and to a battery system comprising two batteries connected in series, two battery monitoring devices and such a voltage level translator device.

US 10,120,033 B2 discloses a battery system comprising two batteries connected in series and two battery monitoring devices.

It is an object of the present invention two enable reliable and easy-to-implement monitoring of a battery system with two batteries connected in series or, more general, to enable reliable and easy-to-implement data communication between data bus devices that are operated at different voltage levels.

This object is solved with a voltage level translator device with the features of claim 1 as well as with a battery system with the features of claim 7.

The voltage level translator device according to the present invention comprises a first data bus terminal and a second data bus terminal which are both designed in a known manner to be connected to a data bus, such as for example a Local Interconnect Network (LIN) bus or a Controller Area Network (CAN) bus.

The voltage level translator device according to the present invention further comprises a first supply voltage terminal and a first reference voltage terminal which are designed in a known manner to be connected to a first external supply potential and a first external reference potential, respectively. The first supply voltage terminal and the first reference voltage terminal may be, for example, designed to be connected to an anode terminal and a cathode terminal of a first external battery, preferably a 12-volt automotive battery, or corresponding terminals of another first external voltage source.

The voltage level translator device according to the present invention further comprises a second supply voltage terminal and a second reference voltage terminal which are designed in a known manner to be connected to a second external supply potential and a second external reference potential, respectively, wherein the second external supply potential and the second external reference potential differ from the first external supply potential and the first external reference potential. The second supply voltage terminal and the second reference voltage terminal may be, for example, designed to be connected to an anode terminal and a cathode terminal of a second external battery, preferably also a 12-volt automotive battery, or corresponding terminals of another second external voltage source. Preferably, a potential difference between the second external supply potential and the second external reference potential is designed to be substantially equal to a potential difference between the first external supply potential and the first external reference potential.

The voltage level translator device according to the present invention further comprises a first transceiver unit which is connected to the first data bus terminal and a second transceiver unit which is connected to the second data bus terminal. The first transceiver unit and the second transceiver unit are both configured in a known, databus-specific manner to transmit and receive data via the first data bus terminal or the second data bus terminal, respectively. The first transceiver unit and the second transceiver unit each comprise a transmit line terminal and a receive line terminal which are designed to be connected to respective terminals of a suitable controller, such as for example a suitable microcontroller, wherein data received via the respective data bus terminal is transmitted via the respective receive line terminal to the respective controller, and wherein data to be transmitted via the respective data bus terminal is received from the respective controller via the respective transmit line terminal. The first transceiver unit is powered in a known manner via the first supply voltage terminal and the first reference voltage terminal, and the second transceiver unit is powered in a known manner via the second supply voltage terminal and the second reference voltage terminal.

The voltage level translator device according to the present invention further comprises a first galvanically isolated signal transmission unit and a second galvanically isolated signal transmission unit which are both configured in a known manner to enable signal transmission between two galvanically isolated circuits. The two galvanically isolated circuits can be coupled, for example, optoelectronically, capacitively or inductively. The first galvanically isolated signal transmission unit and the second galvanically isolated signal transmission unit are preferably based on the same coupling technology. The first galvanically isolated signal transmission unit, more precisely one of the two isolated circuits of the first galvanically isolated signal transmission unit, is connected to the transmit line terminal of the firs transceiver, and the second galvanically isolated signal transmission unit, more precisely one of the two isolated circuits of the second galvanically isolated signal transmission unit, is connected to the receive line terminal of the firs transceiver.

The voltage level translator device according to the present invention further comprises a translation unit with a first transmit line terminal, a first receive line terminal, a second transmit line terminal and a second receive line terminal, i.e., two pairs of transmit/receive line terminals. The first transmit line terminal of the translation unit is connected to the first galvanically isolated signal transmission unit, more precisely to that isolated circuit of the first galvanically isolated signal transmission unit which is not connected to the transmit line terminal of the first transceiver unit, and is thus configured for signal exchange with the transmit line terminal of the first transceiver unit. The first receive line terminal of the translation unit is connected to the second galvanically isolated signal transmission unit, more precisely to that isolated circuit of the second galvanically isolated signal transmission unit which is not connected to the receive line terminal of the first transceiver unit, and is thus configured for signal exchange with the receive line terminal of the first transceiver unit. The second transmit line terminal is connected to the transmit line terminal of the second transceiver unit and is thus configured for signal exchange with the transmit line terminal of the second transceiver unit. The second receive line terminal is connected to the receive line terminal of the second transceiver unit and is thus configured for signal exchange with the receive line terminal of the second transceiver unit. The translation unit is powered in a known manner by the second supply voltage terminal and the second reference voltage terminal.

The translation unit preferably comprises or is constituted by a microcontroller, a system on a chip (SoC), a field-programmable gate array (FPGA) or another type of programmable computing unit. The translation unit is, for example by suitable programming of a computing unit, configured to receive data via the first receive line terminal and transmit the received data unmodified but in a protocol-compliant manner, i.e., in a manner compliant with the protocol of the used data bus, via the second transmit line terminal, and - to realize data transmission in the reverse direction - to receive data via the second receive line terminal and transmit the received data unmodified but in a protocol-compliant manner via the first transmit line terminal. The term data here refers to the payload, i.e., the actual intended message without header and metadata. The translation unit is thus configured, more precisely, to "extract" the payload of a data packet received via one of the receive line terminals, to combine the received payload with suitable header and/or metadata, and to transmit the data packet thus generated via the respective opposite transmit line terminal.

The voltage level translator device according to the present invention is configured to be connected via the second data bus terminal to a data bus and via the first data bus terminal to a data bus device that is operated at different voltage levels than the data bus, wherein the translation unit enables reliable data communication between the data bus device and the data bus.

The voltage level translator device according to the present invention enables reliable and easy-to-implement data communication between data bus devices that are operated at different voltage levels, such as battery monitoring devices of a battery system with two batteries connected in series, and thus enables reliable and easy-to-implement monitoring of a battery system with two batteries connected in series.

In a preferred embodiment, the first galvanically isolated signal transmission unit and/or the second galvanically isolated signal transmission unit, preferably both galvanically isolated signal transmission units, comprise or are constituted by an optocoupler unit, also referred to as opto-isolator (unit), photocoupler (unit) or optical isolator (unit), which transfers electrical signals between the two galvanically isolated circuits optically, i.e., using light. This enables the realization of a relatively compact and inexpensive voltage level translator device. Using optocoupler units also enables relatively high data transmission rates.

Preferably, the translation unit comprises or is constituted by a microcontroller. Microcontrollers are relatively inexpensive, typically comprise at least two pairs of transmit/receive line terminals and can be configured appropriately in a relatively simple manner by suitable programming.

In a preferred embodiment, the first transceiver unit and/or the second transceiver unit, preferably both transceiver units, are each implemented as a suitably designed integrated circuit (IC), also referred to as an application-specific integrated circuit (ASIC), which is commercially available at relatively low cost. Preferably, identical integrated circuits are used for the first transceiver unit and the second transceiver unit.

Since sensor devices are typically operated as a data bus slave device, in a preferred embodiment, the first transceiver unit, which is galvanically isolated from the translation unit, is configured to operate as a data bus master device, and the second transceiver unit is configured to operate as a data bus slave device. This enables the voltage level translator device according to the present invention to be used between a sensor device, for example a battery monitoring device, operated at arbitrary voltage levels, for example at voltage levels of the monitored battery, and a data bus operated at well-defined voltage levels.

In a preferred embodiment, the data bus is a Local Interconnect Network (LIN) bus and the transceiver units as well as the translation unit are configured to comply with the well-known LIN specifications.

The battery system according to the present invention comprises a first battery and a second battery, each of which comprises an anode terminal, also referred to as negative or minus terminal, and a cathode terminal, also referred to as positive or plus terminal. The anode terminal of the second battery is connected to the cathode terminal of the first battery, i.e., the first battery and the second battery are connected in series.

The battery system according to the present invention further comprises a first battery monitoring device and a second battery monitoring device, each of which comprises a data bus terminal. The first battery monitoring device is connected to the anode terminal of the first battery and the cathode terminal of the first battery in order to monitor the first battery, and the second battery monitoring device is connected to the anode terminal of the second battery and the cathode terminal of the second battery in order to monitor the second battery. Both battery monitoring devices are configured in a known manner to be powered by the respective monitored battery. Both battery monitoring devices are further configured in a known manner to monitor parameters of a connected battery such as for example a voltage of the battery, a temperature of the battery, a state-of-charge (SOC) of the battery, a state-of-health (SOH) of the battery or a state-of-function of the battery, and to provide information about the monitored parameters via their data bus terminal. Both battery monitoring devices preferably each comprise an IC or ASIC, respectively, and a low-resistance measuring resistor for measuring a battery current.

The battery system according to the present invention further comprises a control unit which is connected to the anode terminal of the first battery and to the cathode terminal of the first battery so that the control unit is powered by the first battery. The control unit comprises a data bus terminal for data communication with the two battery monitor devices. The control unit typically comprises a microcontroller, a SoC, a FPGA or another type of programmable computing unit. Control units for battery systems are commercially available and are, for example, referred to as master control units, battery management control units or battery control units.

The battery system according to the present invention further comprises a voltage level translator device according to the present invention as described before.

The first data bus terminal of the voltage level translator device, which is galvanically isolated from the translation unit of the voltage level translator device, is connected to the data bus terminal of the second battery monitor device, which is operated at the voltage levels of the second battery. Accordingly, the first supply voltage terminal of the voltage level translator device is connected to the cathode terminal of the second battery and the first reference voltage terminal of the voltage level translator device is connected to the anode terminal of the second battery.

The second data bus terminal of the voltage level translator device, which is operated at the same voltage levels as the translation device of the voltage level translator device, is connected via a data bus to the data bus terminal of the first battery monitor device as well as to the data bus terminal of the control unit, which are both operated at the voltage levels of the first battery. Accordingly, the second supply voltage terminal of the voltage level translator device is connected to the cathode terminal of the first battery and the second reference voltage terminal of the voltage level translator device is connected to the anode terminal of the first battery.

For the reasons described above, the voltage level translator device according to the present invention enables reliable and easy-to-implement data communication between the second battery monitoring device, which is operated at different voltage levels than those of the control unit, and the control unit so that the battery system according to the invention enables reliable and easy-to-implement monitoring of the battery system comprising two batteries connected in series.

In a preferred embodiment, the battery system according to the invention is a 24-volt automotive battery system, wherein the first battery and the second battery both are 12-volt automotive batteries, also referred to as car batteries or starter batteries.

An embodiment of the present invention is described below with reference to the enclosed figures. The figures show:
- Fig. 1: a simplified circuit diagram of a battery system according to the present invention, comprising a voltage level translator device according to the present invention, and
- Fig. 2: a simplified circuit diagram of the voltage level translator device of Fig. 1.

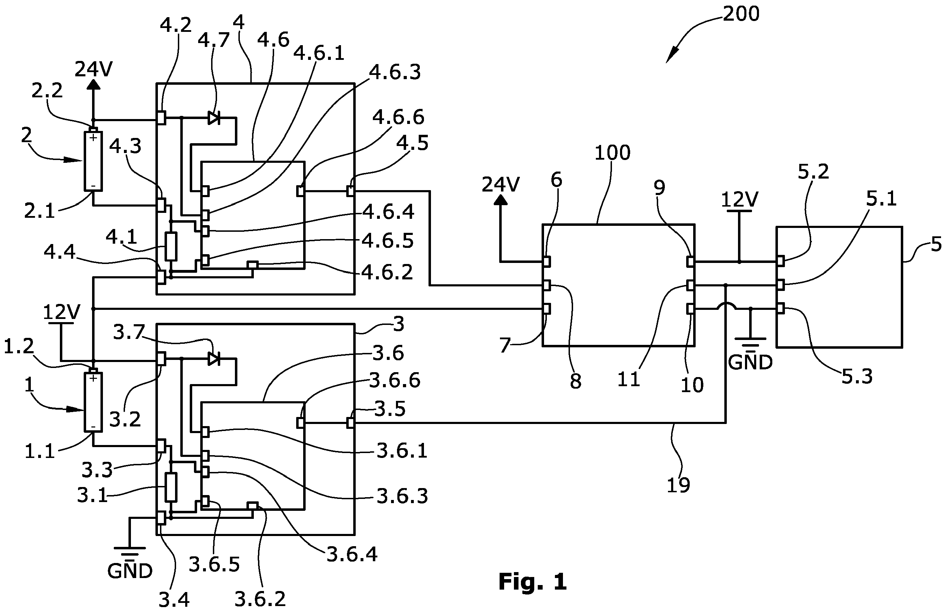

Fig. 1 shows a simplified circuit diagram of a battery system 200 according to the present invention, which in the present use case is exemplarily a 24-volt automotive battery system, and which comprises a first battery 1, a second battery 2, a first battery monitoring device 3, a second battery monitoring device 4, a control unit 5 and a voltage level translator device 100 according to the present invention.

The first battery 1, which in the present use case is a 12-volt automotive battery, comprises an anode terminal 1.1 and a cathode terminal 1.2, and the second battery 2, which in the present use case is also a 12-volt automotive battery, comprises an anode terminal 2.1 and a cathode terminal 2.2.

The anode terminal 2.1 of the second battery 2 is connected to the cathode terminal 1.2 of the first battery 1 via a measuring resistor 4.1 of the second battery monitoring device 4 so that the first battery 1 and the second battery 2 are connected in series.

The anode terminal 1.1 of the first battery 1 is connected to a ground potential GND of the battery system 200 via a measuring resistor 3.1 of the first battery monitoring device 3.

The cathode terminal 1.2 of the first battery 1 defines a 12-volt potential 12V of the battery system 200, and the cathode terminal 2.2 of the second battery 2 defines a 24-volt potential 24V of the battery system 200.

The first battery monitoring device 3 comprises a battery cathode terminal 3.2 connected to the cathode terminal 1.2 of the first battery 1, a battery anode terminal 3.3 connected to the anode terminal 1.1 of the first battery 1, a reference potential terminal 3.4 connected to the ground potential GND, and a data bus terminal 3.5 connected to a data bus 19 which is implemented as a LIN bus.

The first battery monitoring device 3 comprises an integrated circuit 3.6.

The integrated circuit 3.6 comprises a supply voltage terminal 3.6.1 connected to the battery cathode terminal 3.2 via a diode 3.7, a reference voltage terminal 3.6.2 connected to the reference potential terminal 3.4, a battery voltage terminal 3.6.3 connected to the battery cathode terminal 3.2, a first measuring resistor terminal 3.6.4, connected to a first end of the measuring resistor 3.1, a second measuring resistor terminal 3.6.5 connected to a second end of the measuring resistor 3.1, and a data bus terminal 3.6.6 connected to the data bus terminal 3.5.

The second battery monitoring device 4 comprises a battery cathode terminal 4.2 connected to the cathode terminal 2.2 of the second battery 2, a battery anode terminal 4.3 connected to the anode terminal 2.1 of the second battery 2, a reference potential terminal 4.4 connected to the 12-volt potential 12V, and a data bus terminal 4.5.

The second battery monitoring device 4 comprises an integrated circuit 4.6.

The integrated circuit 4.6 comprises a supply voltage terminal 4.6.1 connected to the battery cathode terminal 4.2 via a diode 4.7, a reference voltage terminal 4.6.2 connected to the reference potential terminal 4.4, a battery voltage terminal 4.6.3 connected to the battery cathode terminal 4.2, a first measuring resistor terminal 4.6.4, connected to a first end of the measuring resistor 4.1, a second measuring resistor terminal 4.6.5 connected to a second end of the measuring resistor 4.1, and a data bus terminal 4.6.6 connected to the data bus terminal 4.5.

The voltage level translator device 100 comprises a first supply voltage terminal 6 connected to the 24-volt potential 24V and thus to the cathode terminal 2.2 of the second battery 2, a first reference voltage terminal 7 connected to the 12-volt potential 12V and thus to the cathode terminal 1.2 of the first battery 1, a first data bus terminal 8 connected to the data bus terminal 4.5, a second supply voltage terminal 9 connected to the 12-volt potential 12V and thus to the cathode terminal 1.2 of the first battery 1, a second reference voltage terminal 10 connected to the ground potential GND and thus to the anode terminal 1.1 of the first battery 1, a second data bus terminal 11 connected to the data bus terminal 3.5 and to a data bus terminal 5.1 of the control unit 5 via the data bus 19.

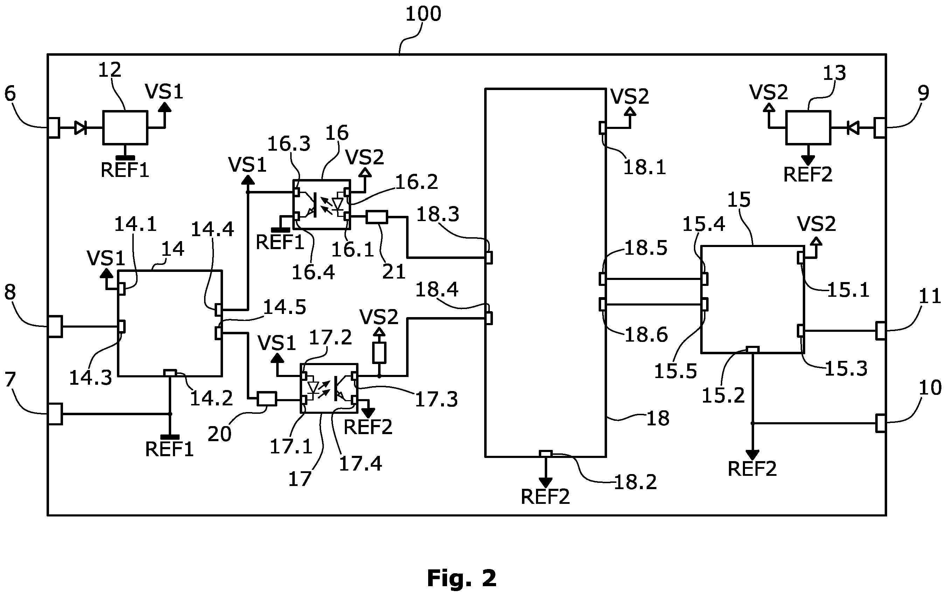

The voltage level translator device 100 is described in more detail below with reference to Fig. 2.

The control unit 5 comprises a supply voltage terminal 5.2 connected to the 12-volt potential 12V and thus to the cathode terminal 1.2 of the first battery 1, and a reference voltage terminal 5.3 connected to the ground potential GND and thus to the anode terminal 1.1 of the first battery 1, so that the control unit 5 is powered by the first battery 1.

Fig. 2 shows a simplified circuit diagram of the voltage level translator device 100.

The first reference voltage terminal 7 defines a first internal reference potential REF1 of the voltage level translator device 100, and the second reference voltage terminal 10 defines a second internal reference potential REF2 of the voltage level translator device 100.

The voltage level translator device 100 comprises a first voltage supply device 12 which is connected to the first supply voltage terminal 6 via a diode and with the first internal reference potential REF1, and which is configured to output a first internal supply potential VS1.

The voltage level translator device 100 further comprises a second voltage supply device 13 which is connected to the second supply voltage terminal 9 via a diode and with the second internal reference potential REF2, and which is configured to output a second internal supply potential VS2.

The voltage level translator device 100 further comprises a first transceiver unit 14 which is implemented as an integrated circuit.

The first transceiver unit 14 comprises a supply voltage terminal 14.1 connected to the first internal supply potential VS1 and a reference voltage terminal 14.2 connected to the first internal reference potential REF1, so that the first transceiver unit 14 is powered via the first supply voltage terminal 6 and the first reference voltage terminal 7.

The first transceiver unit 14 further comprises a data bus terminal 14.3 connected to the first data bus terminal 8 for data communication with the second battery monitoring device 4, wherein the first transceiver unit 14 is configured to operate as a data bus master device with respect to the battery monitoring device 4.

The first transceiver unit 14 further comprises a transmit line terminal 14.4 for receiving data to be transmitted via the data bus terminal 14.3 and a receive line terminal 14.5 for transmitting data received via the data bus terminal 14.3.

The voltage level translator device 100 further comprises a second transceiver unit 15 which is implemented as an integrated circuit.

The second transceiver unit 15 comprises a supply voltage terminal 15.1 connected to the second internal supply potential VS2 and a reference voltage terminal 15.2 connected to the second internal reference potential REF2, so that the first transceiver unit 15 is powered via the second supply voltage terminal 9 and the second reference voltage terminal 10.

The second transceiver unit 15 further comprises a data bus terminal 15.3 connected to the second data bus terminal 11 for data communication via the data bus 19, wherein the second transceiver unit 15 is configured to operate as a data bus slave device with respect to the data bus 19.

The second transceiver unit 15 further comprises a transmit line terminal 15.4 for receiving data to be transmitted via the data bus terminal 15.3 and a receive line terminal 15.5 for transmitting data received via the data bus terminal 15.3.

The voltage level translator device 100 further comprises a first galvanically isolated signal transmission unit 16 which is implemented as an optocoupler unit.

The first galvanically isolated signal transmission unit 16 comprises an signal input terminal 16.1, an input supply voltage terminal 16.2 connected to the second internal supply potential VS2, a signal output terminal 16.3 connected to the transmit line terminal 14.4, and an output reference voltage terminal 16.4 connected to the first internal reference potential REF1, wherein the signal input terminal 16.1 and the input supply voltage terminal 16.2 are galvanically isolated from the signal output terminal 16.3 and the output reference voltage terminal 16.4.

The first galvanically isolated signal transmission unit 16 is configured to output a signal that is input via the signal input terminal 16.1 via the signal output terminal 16.3.

The voltage level translator device 100 further comprises a second galvanically isolated signal transmission unit 17 which is implemented as an optocoupler unit.

The second galvanically isolated signal transmission unit 17 comprises an signal input terminal 17.1 connected to the receive line terminal 14.5 via a resistor 20, an input supply voltage terminal 17.2 connected to the first internal supply potential VS1, a signal output terminal 17.3, and an output reference voltage terminal 17.4 connected to the second internal reference potential REF2, wherein the signal input terminal 17.1 and the input supply voltage terminal 17.2 are galvanically isolated from the signal output terminal 17.3 and the output reference voltage terminal 17.4.

The second galvanically isolated signal transmission unit 17 is configured to output a signal that is input via the signal input terminal 17.1 via the signal output terminal 17.3.

The voltage level translator device 100 further comprises a translation unit 18 which is implemented as a microcontroller.

The translation unit 18 comprises a supply voltage terminal 18.1 connected to the second internal supply potential VS2 and a reference voltage terminal 18.2 connected to the second internal reference potential REF2, so that the translation unit 18 is powered via the second supply voltage terminal 9 and the second reference voltage terminal 10.

The translation unit 18 comprises a first transmit line terminal 18.3 connected to the signal input terminal 16.1 via a resistor 21 for transmitting data via the first galvanically isolated signal transmission unit 16 to the transmit line terminal 14.4, and a first receive line terminal 18.4 connected to the signal output terminal 17.3 for receiving data via the second galvanically isolated signal transmission unit 17 from the receive line terminal 14.5.

The translation unit 18 further comprises a second transmit line terminal 18.5 connected to the transmit line terminal 15.4 for transmitting data to the transmit line terminal 15.4, and a second receive line terminal 18.6 connected to the receive line terminal 15.5 for receiving data from the receive line terminal 15.5.

The translation unit 18 is configured to receive data via the first receive line terminal 18.4 and transmit the received data in a protocol-compliant manner, i.e., in a manner compliant with the LIN bus protocol, via the second transmit line terminal 18.5, and to receive data via the second receive line terminal 18.6 and transmit the received data in a protocol-compliant manner via the first transmit line terminal 18.3.

### List of Reference Numerals

- 200: battery system
- 1: first battery
- 1.1: anode terminal
- 1.2: cathode terminal
- 2: second battery
- 2.1: anode terminal
- 2.2: cathode terminal
- 3: first battery monitoring device
- 3.1: measuring resistor
- 3.2: battery cathode terminal
- 3.3: battery anode terminal
- 3.4: reference potential terminal
- 3.5: data bus terminal
- 3.6: integrated circuit
- 3.6.1: supply voltage terminal
- 3.6.2: reference voltage terminal
- 3.6.3: battery voltage terminal
- 3.6.4: first measuring resistor terminal
- 3.6.5: second measuring resistor terminal
- 3.6.6: data bus terminal
- 3.7: diode
- 4: second battery monitoring device
- 4.1: measuring resistor
- 4.2: battery cathode terminal
- 4.3: battery anode terminal
- 4.4: reference potential terminal
- 4.5: data bus terminal
- 4.6: integrated circuit
- 4.6.1: supply voltage terminal
- 4.6.2: reference voltage terminal
- 4.6.3: battery voltage terminal
- 4.6.4: first measuring resistor terminal
- 4.6.5: second measuring resistor terminal
- 4.6.6: data bus terminal
- 4.7: diode
- 5: control unit
- 5.1: data bus terminal
- 5.2: supply voltage terminal
- 5.3: reference voltage terminal
- 19: data bus

- 100: voltage level translator device
- 6: first supply voltage terminal
- 7: first reference voltage terminal
- 8: first data bus terminal
- 9: second supply voltage terminal
- 10: second reference voltage terminal
- 11: second data bus terminal
- 12: first voltage supply device
- 13: second voltage supply device
- 14: first transceiver unit
- 14.1: supply voltage terminal
- 14.2: reference voltage terminal
- 14.3: data bus terminal
- 14.4: transmit line terminal
- 14.5: receive line terminal
- 15: second transceiver unit
- 15.1: supply voltage terminal
- 15.2: reference voltage terminal
- 15.3: data bus terminal
- 15.4: transmit line terminal
- 15.5: receive line terminal
- 16: first galvanically isolated signal transmission unit
- 16.1: signal input terminal
- 16.2: input supply voltage terminal
- 16.3: signal output terminal
- 16.4: output reference voltage terminal
- 17: second galvanically isolated signal transmission unit
- 17.1: signal input terminal
- 17.2: input supply voltage terminal
- 17.3: signal output terminal
- 17.4: output reference voltage terminal
- 18: translation unit
- 18.1: supply voltage terminal
- 18.2: reference voltage terminal
- 18.3: first transmit line terminal
- 18.4: first receive line terminal
- 18.5: second transmit line terminal
- 18.6: second receive line terminal
- 20: resistor
- 21: resistor

- 12V: 12-volt potential
- 24V: 24-volt potential
- GND: ground potential
- REF1: first internal reference potential
- REF2: second internal reference potential
- VS1: first internal supply potential
- VS2: second internal supply potential

## Claims

1. Voltage level translator device (100) for a data bus (19), comprising:
a first data bus terminal (8), a first supply voltage terminal (6), a first reference voltage terminal (7), a second data bus terminal (11), a second supply voltage terminal (9) and a second reference voltage terminal (10), a first transceiver unit (14) comprising a transmit line terminal (14.4) and a receive line terminal (14.5), wherein the first transceiver unit (14) is powered via the first supply voltage terminal (6) and the first reference voltage terminal (7) and is connected to the first data bus terminal (8),
a first galvanically isolated signal transmission unit (16) connected to the transmit line terminal (14.4) of the first transceiver unit (14),
a second galvanically isolated signal transmission unit (17) connected to the receive line terminal (14.5) of the first transceiver unit (14),
a second transceiver unit (15) comprising a transmit line terminal (15.4) and a receive line terminal (15.5), wherein the second transceiver unit (15) is powered via the second supply voltage terminal (9) and the second reference voltage terminal (10) and is connected to the second data bus terminal (11), and
a translation unit (18) comprising a first transmit line terminal (18.3) connected to the first galvanically isolated signal transmission unit (16), a first receive line terminal (18.4) connected to the second galvanically isolated signal transmission unit (17), a second transmit line terminal (18.5) connected to the transmit line terminal (15.4) of the second transceiver unit (15), and a second receive line terminal (18.6) connected to the receive line terminal (15.5) of the second transceiver unit (15), wherein the translation unit (18) is powered via the second supply voltage terminal (9) and the second reference voltage terminal (10), and wherein the translation unit (18) is configured to receive data via the first receive line terminal (18.4) and transmit the received data in a protocol-compliant manner via the second transmit line terminal (18.5), and to receive data via the second receive line terminal (18.6) and transmit the received data in a protocol-compliant manner via the first transmit line terminal (18.3).

2. Voltage level translator device (100) according to claim 1, wherein the first galvanically isolated signal transmission unit (16) and/or the second galvanically isolated signal transmission unit (17) comprise an optocoupler unit.

3. Voltage level translator device (100) according to one of the preceding claims, wherein the translation unit (18) comprises a microcontroller.

4. Voltage level translator device (100) according to one of the preceding claims, wherein the first transceiver unit (14) and/or the second transceiver unit (15) are implemented as an integrated circuit.

5. Voltage level translator device (100) according to one of the preceding claims, wherein the first transceiver unit (14) is configured to operate as a data bus master device and the second transceiver unit (15) is configured to operate as a data bus slave device.

6. Voltage level translator device (100) according to one of the preceding claims, wherein the data bus (19) is a LIN bus.

7. Battery system (200) comprising:
a first battery (1) comprising an anode terminal (1.1) and a cathode terminal (1.2),
a second battery (2) comprising an anode terminal (2.1) and a cathode terminal (2.2), wherein the anode terminal (2.1) of the second battery (2) is connected to the cathode terminal (1.2) of the first battery (1),
a first battery monitoring device (3) comprising a data bus terminal (3.5) and connected to the anode terminal (1.1) of the first battery (1) and the cathode terminal (1.2) of the first battery (1),
a second battery monitoring device (4) comprising a data bus terminal (4.5) and connected to the anode terminal (2.1) of the second battery (2) and the cathode terminal (2.2) of the second battery (2),
a control unit (5) powered by the first battery (1) and comprising a data bus terminal (5.1) connected to the data bus terminal (3.5) of the first battery monitoring device (3) via a data bus (19), and
a voltage level translator device (100) according to one of the preceding claims, wherein the first data bus terminal (8) is connected to the data bus terminal (4.5) of the second battery monitor device (4), the second data bus terminal (11) is connected to the data bus terminal (3.5) of the first battery monitor device (3) as well as to the data bus terminal (5.1) of the control unit (5) via the data bus (19), the first supply voltage terminal (6) is connected to the cathode terminal (2.2) of the second battery (2), the first reference voltage terminal (7) as well as the second supply voltage terminal (9) are both connected to the cathode terminal (1.2) of the first battery (1), and the second reference voltage terminal (10) is connected to the anode terminal (1.1) of the first battery (1).

8. Battery system (200) according to claim 7, wherein the first battery (1) and the second battery (2) both are automotive batteries.
